# EUROPEAN PATENT APPLICATION

(11) **EP 4 376 570 A1**
(43) Date of publication of application: **29.05.2024**
(21) Application number: 23212386.9
(22) Date of filing: 27.11.2023
(51) Int. Cl.: H10K 50/813, H10K 50/818, H10K 59/80, H10K 102/00

(54) **ORGANIC DEVICE, DISPLAY APPARATUS INCLUDING THE SAME, PHOTOELECTRIC CONVERSION APPARATUS, ELECTRONIC APPARATUS, ILLUMINATION APPARATUS, MOVING OBJECT, AND WEARABLE DEVICE**

(30) Priority: 28.11.2022 JP 2022189341
(71) Applicant: CANON KABUSHIKI KAISHA, Tokyo 146-8501 (JP)
(72) Inventor: MAKAINO, Akinori, Tokyo, 146-8501 (JP); USUI, Takashi, Ohta-ku, 146-8501 (JP); SHOYAMA, Toshihiro, Ohta-ku, 146-8501 (JP)
(74) Representative: Canon Europe Limited

(57) **Abstract**

An organic device (1) includes a reflection layer (110), a first electrode (130), an organic layer (150), and a second electrode (160) arranged in that order above a first principal surface of a substrate (100). The first electrode includes first to fourth regions. The first region (S1) is in contact with the organic layer. The second region being (S2) is inclined in a direction away from the substrate. The third region (S3) has an inclination less than that of the second region with respect to the substrate. The fourth region (S4) is inclined in the direction away from the substrate and has an inclination greater than that of the third region with respect to the substrate. The first and second regions are in contact with each other. The second and third regions are in contact with each other. The third and fourth regions are in contact with each other.

## Description

### BACKGROUND OF THE INVENTION

### Field of the Invention

The present invention relates to an organic device, a display apparatus including the organic device, a photoelectric conversion apparatus, an electronic apparatus, an illumination apparatus, a moving object, and a wearable device.

### Description of the Related Art

In recent years, an optical resonator structure has been used in an organic electroluminescence device (hereinafter also referred to as "organic EL device", "organic light emitting element", or "organic device"). An organic device including the optical resonator structure includes a transparent electrode as an anode. Light emitted from the organic device passes through the transparent electrode, and the transmitted light is reflected by a reflection layer. The light emitted from the organic device and the reflected light enhance each other by interference, thereby increasing the luminous efficiency of the organic device. Japanese Patent Laid-Open No. 2021-72282 (PTL1) discloses an organic device including the optical resonator structure.

The organic device described in PTL1 tends to have a thin electrode on an inclined portion, and the electrode may break.

### SUMMARY OF THE INVENTION

The present invention provides an organic device in which breakage of an electrode does not easily occur.

The present invention in its first aspect provides an organic device as specified in claims 1 to 9.

The present invention in its second aspect provides a photoelectric conversion apparatus as specified in claim 10.

The present invention in its third aspect provides a display apparatus as specified in claim 11.

The present invention in its fourth aspect provides an electronic apparatus as specified in claim 12.

The present invention in its fifth aspect provides an illumination apparatus as specified in claim 13.

The present invention in its sixth aspect provides a moving object as specified in claim 14.

The present invention in its seventh aspect provides a wearable device as specified in claim 15.

Further features of the present invention will become apparent from the following description of embodiments with reference to the attached drawings.

### BRIEF DESCRIPTION OF THE DRAWINGS

Fig. 1A is a sectional view of an organic device according to a first embodiment of the present invention. Fig. 1B illustrates a modification of the first embodiment.
Fig. 2 is a plan view of the organic device according to the first embodiment of the present invention.
Figs. 3A and 3B are sectional views of the organic device according to the first embodiment of the present invention. Fig. 3C illustrates a shape according to the structure of the related art.
Figs. 4A to 4K illustrate a method for manufacturing the organic device according to the first embodiment of the present invention. Figs. 4C' to 4J' illustrate a method according to the related art.
Figs. 5A and 5B illustrate a method for manufacturing an organic device according to a second embodiment of the present invention.
Figs. 6A to 6D illustrate a method for manufacturing an organic device according to a third embodiment of the present invention.
Fig. 7 is a schematic diagram illustrating an example of a display apparatus according to an embodiment of the present invention.
Fig. 8A is a schematic diagram illustrating an example of an imaging device according to an embodiment of the present invention. Fig. 8B is a schematic diagram illustrating an example of an electronic apparatus according to an embodiment of the present invention.
Fig. 9A is a schematic diagram illustrating an example of a display apparatus according to an embodiment of the present invention. Fig. 9B is a schematic diagram illustrating an example of a foldable display apparatus.
Fig. 10A is a schematic diagram illustrating an example of an illumination apparatus according to an embodiment of the present invention. Fig. 10B is a schematic diagram illustrating an example of an automobile including a vehicle light according to an embodiment of the present invention.
Fig. 11A is a schematic diagram illustrating an example of a wearable device according to an embodiment of the present invention. Fig. 11B is a schematic diagram illustrating an example of a wearable device including an imaging device according to an embodiment of the present invention.

### DESCRIPTION OF THE EMBODIMENTS

Embodiments of the present invention will now be described in detail with reference to the accompanying drawings. The embodiments described below do not limit the invention defined by the claims. Although the embodiments have a plurality of features, not all of the features are essential to the invention, and the features may be combined in any way. Each of the embodiments of the present invention described below can be implemented solely or as a combination of a plurality of the embodiments or features thereof where necessary or where the combination of elements or features from individual embodiments in a single embodiment is beneficial. In the accompanying drawings, the same or similar structures are denoted by the same reference numerals, and redundant description will be omitted.

### First Embodiment

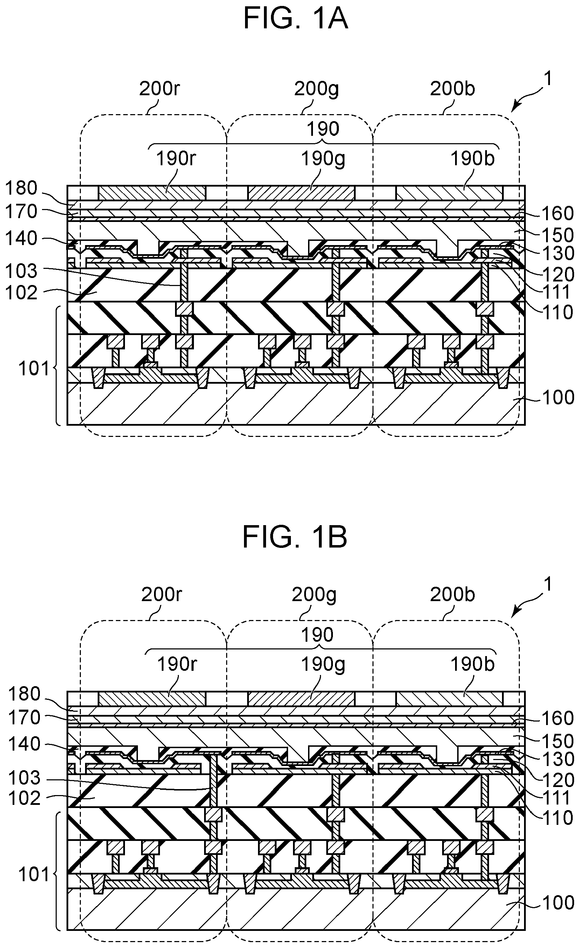

An organic device 1 according to a first embodiment will be described with reference to Figs. 1A to 3C. Fig. 1A is a sectional view of the organic device 1 according to the first embodiment. Fig. 1B illustrates a modification of the first embodiment.

The organic device 1 according to the present invention includes a reflection layer 110, a first electrode 130, an organic layer 150, and a second electrode 160 arranged in that order above a first principal surface of a substrate 100. The organic device according to the present embodiment also includes a drive circuit layer 101 and an interlayer insulating layer 102 on the first principal surface of the substrate 100.

The interlayer insulating layer 102 includes first conductive plugs 103. The first conductive plugs 103 connect the drive circuit layer 101 and the reflection layer 110 to each other. More specifically, a wiring layer included in the drive circuit layer 101 is connected to the reflection layer 110. As illustrated in Fig. 1B, the first conductive plugs 103 may connect the drive circuit layer 101 and the first electrode 130 to each other without connection to the reflection layer 110.

An antireflection layer 111 is provided on the reflection layer 110. A first insulating layer 120, the first electrode 130, a second insulating layer 140, the organic layer 150, and the second electrode 160 are arranged in that order on the antireflection layer 111. A moisture proof layer 170, a first flattening layer 180, and a color filter layer 190 may be arranged in that order on the second electrode 160. The organic device according to the present invention may also include microlenses.

In the organic device according to the present invention, the color filter layer 190 may be disposed to overlap inclined portions of the first electrode 130. To improve viewing angle characteristics, the color filter layer 190 may be disposed to partially overlap the inclined portions of the first electrode 130. This also applies to microlenses. The microlenses may also be disposed to overlap, or partially overlap, the inclined portions of the first electrode 130.

The substrate 100 may be a semiconductor substrate, such as a silicon substrate, or a resin substrate.

The material of the interlayer insulating layer 102, the first insulating layer 120, and the second insulating layer 140 may be silicon oxide, silicon oxynitride, or silicon nitride. To ensure good workability, the material may be silicon oxide.

The first conductive plugs 103 may be made of any material capable of electrically connecting the drive circuit layer 101 and the reflection layer 110 to each other. For example, a conductive material such as tungsten (W) may be used. The first conductive plugs 103 may contain a barrier metal, such as titanium (Ti), titanium nitride (TiN), or Ti/TiN.

The reflection layer 110 may be made of any material capable of reflecting light. The material may have a reflectance of 80% or more. More specifically, the material may be a high-reflectance material, such as aluminum (Al), silver (Ag), or platinum (Pt), or an alloy (for example, AlCu) containing these high-reflectance materials.

The antireflection layer 111 may be made of any material capable of reducing reflection of light. For example, Ti, TiN, or Ti/TiN may be used.

The first electrode 130 may be made of any material capable of transmitting light emitted from the organic layer 150 toward the substrate 100, and may be a transparent material. For example, indium tin oxide (ITO) or indium zinc oxide (IZO) may be used.

In the organic device according to the present embodiment, the drive circuit layer 101 formed on the substrate 100 transmits an electric signal to the first electrode 130, so that the organic layer 150 emits light. A portion of the light emitted by the organic layer 150 is reflected by the reflection layer 110. The light emitted by the organic layer 150 and the reflected light enhance each other by interference. Therefore, the organic device according to the present invention can be regarded as including an optical resonator structure. More specifically, light emitted by the organic layer 150 toward the second electrode 160 and light emitted by the organic layer 150 and reflected by the reflection layer 110 enhance each other by interference in the organic layer 150.

An optical adjustment film thickness D1 described below may be adjusted so that the light emitted by the organic layer 150 toward the second electrode 160 and the light emitted by the organic layer 150 and reflected by the reflection layer 110 more efficiently enhance each other by interference. The light enhanced by interference as described above is emitted through color filters 190r, 190g, and 190b corresponding to respective colors.

In this specification, a specific one of the color filters 190 is referred to as, for example, a color filter 190"r" with a reference numeral followed by a subscript. A color filter that can be any of the color filters is simply referred to as a color filter "190". This also applies to other components.

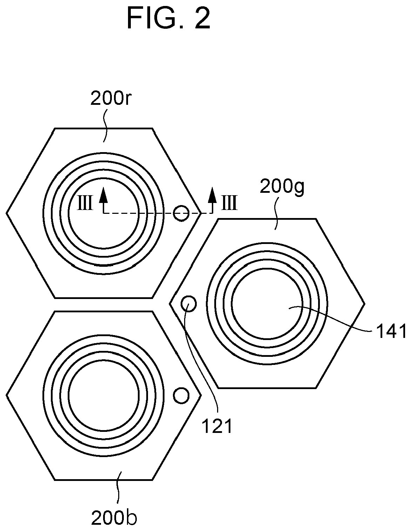

Fig. 2 is a plan view illustrating a structure obtained after formation of the second insulating layer 140. The organic device 1 includes a plurality of pixels 200. The reflection layer 110 and the first electrode 130 are electrically connected to each other. The second insulating layer 140 has openings 141 for providing connection between the first electrode 130 and the organic layer 150.

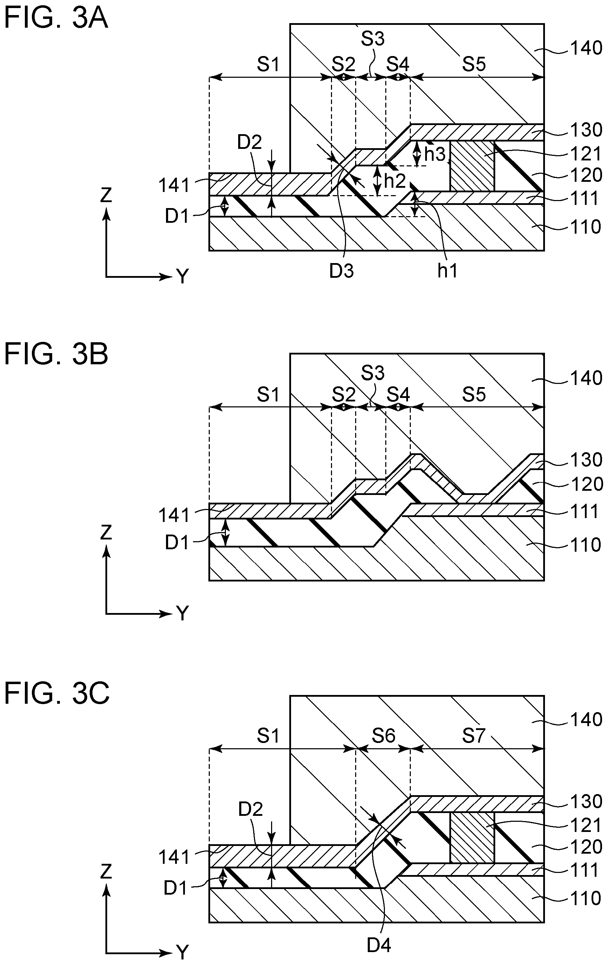

Fig. 3A is a sectional view of a first pixel 200r taken along line III-III in Fig. 2. To increase the light reflectance, the organic device according to the present invention may have no antireflection layer 111 in the opening 141. The antireflection layer 111 may be removed by photolithography or dry etching.

As described above, the reflection layer 110 and the first electrode 130 are electrically connected to each other. As illustrated in Fig. 3A, the reflection layer 110 and the first electrode 130 may be connected to each other by a second conductive plug 121. As illustrated in Fig. 3B, the antireflection layer 111 and the first electrode 130 may be directly in contact with each other so that the reflection layer 110 and the first electrode 130 are electrically connected to each other.

The second conductive plug 121 may be made of any material capable of electrically connecting the reflection layer 110 and the first electrode 130 to each other. For example, a conductive material such as tungsten (W) may be used. The second conductive plug 121 may contain a barrier metal, such as Ti, TiN, or Ti/TiN.

The first electrode 130 included in the organic device according to the present invention includes the following regions: a first region S1, a second region S2, a third region S3, and a fourth region S4. The first region S1 and the second region S2 are in contact with each other. The second region S2 and the third region S3 are in contact with each other. The third region S3 and the fourth region S4 are in contact with each other. The first electrode 130 may additionally include a fifth region S5 in contact with the fourth region S4.

The first region S1 includes a region in contact with the organic layer 150. More specifically, the first region S1 is in contact with the organic layer 150 in the opening 141. The first electrode 130 has a film thickness D2 in the first region S1. To ensure sufficient conductivity, the film thickness D2 may be 20 nm or more and 100 nm or less.

A portion of the first insulating layer 120 disposed in the first region S1 has a film thickness D1 referred to as an optical adjustment film thickness. D1 may be adjusted so that light emitted from each pixel 200 and light reflected by the reflection layer 110 enhance each other by interference. The organic device according to the present embodiment includes the plurality of pixels 200. More specifically, the first pixel 200r, a second pixel 200g, and a third pixel 200b are provided. When the first pixel 200r, the second pixel 200g, and the third pixel 200b emit light in different colors, D1 may differ between the pixels. For example, when the first pixel 200r, the second pixel 200g, and the third pixel 200b emit red (R) light, green (G) light, and blue (B) light, respectively, D1 decreases in the order of the first pixel 200r, the second pixel 200g, and the third pixel 200b.

The second region S2 is inclined in the direction away from the substrate 100. The inclination angle of the first electrode 130 in the second region S2 may be 30° or more and 50° or less. The inclined portion in the second region S2 has a height h2 in inverse proportion to D1. More specifically, h2 is small in a pixel with a large D1, and is large in a pixel with a small D1. Here, h2 is the distance in a direction perpendicular to the first principal surface from the lower surface of the first electrode 130 in the first region S1 to the lower surface of the first electrode 130 at the highest position in the second region S2. Since the second region S2 includes an inclined portion, the first electrode 130 cannot be formed easily in the second region S2. Therefore, the first electrode 130 has a film thickness D3 less than D2 in the second region S2.

The inclination of the third region S3 relative to the substrate 100 is less than that of the second region S2. In the third region, the first electrode 130 may be parallel to the substrate 100 or be inclined in the direction away from the substrate 100. More specifically, the inclination angle of the first electrode 130 in the third region S3 may be 0° or more and 20° or less. In the organic device according to the present embodiment, the inclination angle of the first electrode 130 in the third region S3 is assumed to be 0°. The film thickness of the first electrode 130 in the third region S3 is greater than D3. In the organic device according to the present embodiment, the film thickness of the first electrode 130 in the third region S3 is close to D1.

The inclination of the fourth region S4 relative to the substrate 100 is greater than that of the third region S3. The fourth region S4 is inclined in the direction away from the substrate 100. The inclination angle of the first electrode 130 in the fourth region S4 may be close to an inclination angle of the reflection layer 110 and the antireflection layer 111 in the process of removing the antireflection layer 111, and may be 30° or more and 50° or less. The inclined portion in the fourth region S4 may have a height h3 close to a height h1 of the reflection layer 110 and the antireflection layer 111 in the process of removing the antireflection layer 111. Here, h1 is the distance in the direction perpendicular to the first principal surface from the lowest position of the upper surface of the reflection layer 110 to the upper surface of the antireflection layer 111. In addition, h3 is the distance in the direction perpendicular to the first principal surface from the lower surface of the first electrode 130 at the highest position in the third region S3 to the lower surface of the first electrode 130 at the highest position in the fourth region S4. Similarly to D3, the film thickness of the first electrode 130 in the fourth region S4 is less than D2.

The fifth region S5 includes a region in which the first electrode 130 and the reflection layer 110 are electrically connected to each other. The structure is not particularly limited as long as the first electrode 130 and the reflection layer 110 are electrically connected to each other. For example, as illustrated in Fig. 3A, the first electrode 130 and the reflection layer 110 may be electrically connected to each other by the second conductive plug 121. Alternatively, as illustrated in Fig. 3B, the first electrode 130 and the antireflection layer 111 may be directly in contact with each other so that the first electrode 130 and the reflection layer 110 are electrically connected to each other.

Fig. 3C illustrates a shape according to the related art in which the structure of the present invention is not applied. In the shape according to the related art, the first electrode 130 includes a first region S1, a sixth region S6 connected to the first region S1, and a seventh region S7 connected to the sixth region S6. The first region S1 is similar to the first region S1 described above.

The sixth region S6 is inclined relative to the substrate 100 in the direction away from the substrate 100. The inclination of the seventh region S7 relative to the substrate 100 is less than that of the sixth region S6. The seventh region S7 may include a region in which the first electrode 130 and the reflection layer 110 are electrically connected to each other. The method for electrically connecting the first electrode 130 and the reflection layer 110 to each other is similar to the above-described method in the fifth region S5.

The shape according to the related art does not include a region corresponding to the third region S3 according to the present invention. More specifically, one inclined portion extends between the first region S1 and the seventh region S7.

As described above, the first electrode 130 cannot be formed easily in regions including an inclined portion. Therefore, a film thickness D4 of the first electrode 130 in the sixth region S6 is less than the film thickness D2 of the first electrode 130 in the first region.

Since the shape according to the related art includes only one inclined portion, the first electrode 130 may have a higher resistance and break easily. In particular, when the thickness of the first electrode 130 is reduced, D4 is further reduced in the shape according to the related art. Therefore, the first electrode 130 may have an even higher resistance and break more easily.

In contrast, in the organic device according to the present invention, a plurality of inclined portions are provided between the first region S 1 and the fifth region S5, so that the increase in resistance and breakage of the first electrode 130 can be reduced. In particular, even when the thickness of the first electrode 130 is reduced, the increase in resistance and breakage of the first electrode 130 can be reduced. According to the organic device of the present invention, since the thickness of the first electrode 130 can be reduced, absorption of light by the first electrode 130 can be reduced. For this reason, the organic device according to the present invention is also advantageous in terms of power consumption.

The thickness of the first electrode 130 may be reduced to, for example, 30 nm or less.

Although the organic device according to the present embodiment includes two inclined portions, the number of inclined portions is not limited to this. Specifically, three or more inclined portions may be provided. As the number of inclined portions increases, the height of each inclined portion decreases, and the increase in resistance and breakage of the first electrode 130 can be further reduced.

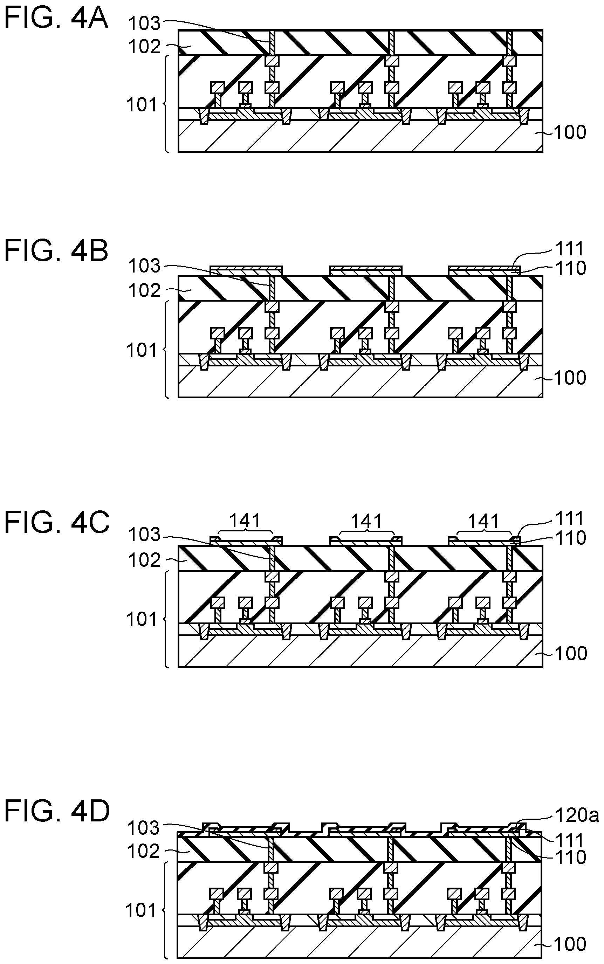

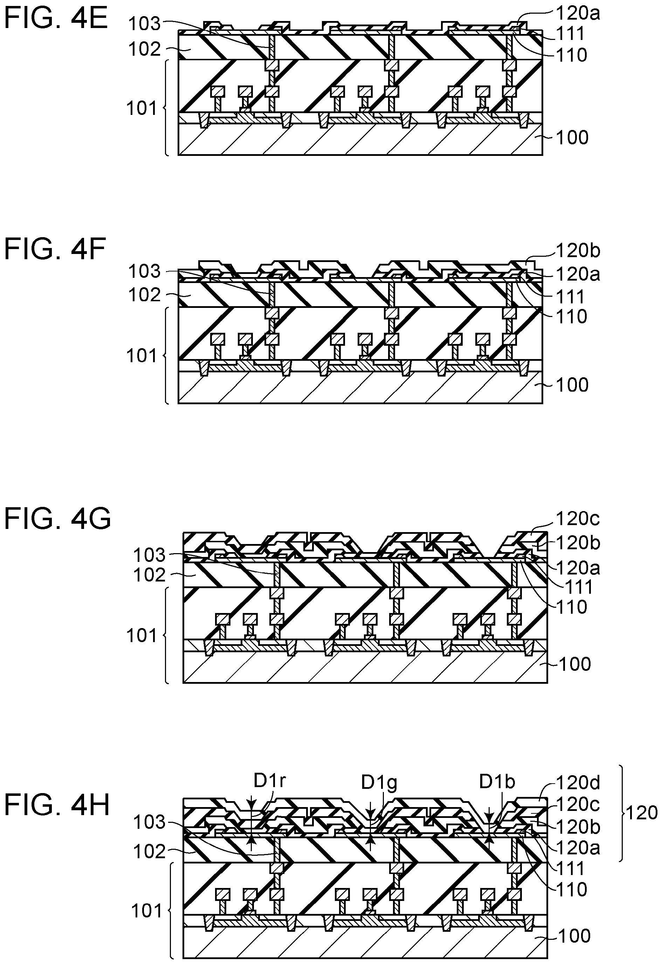

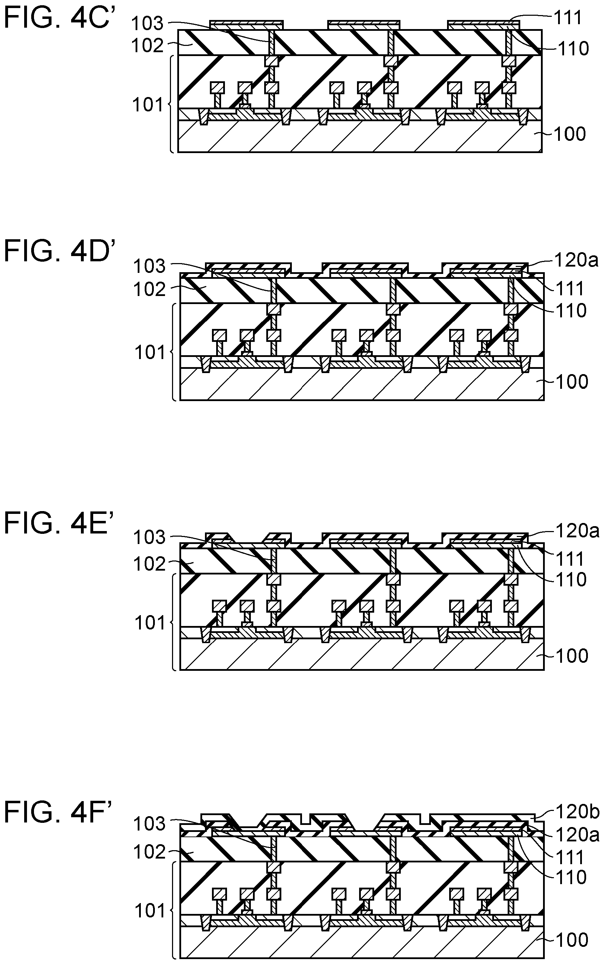

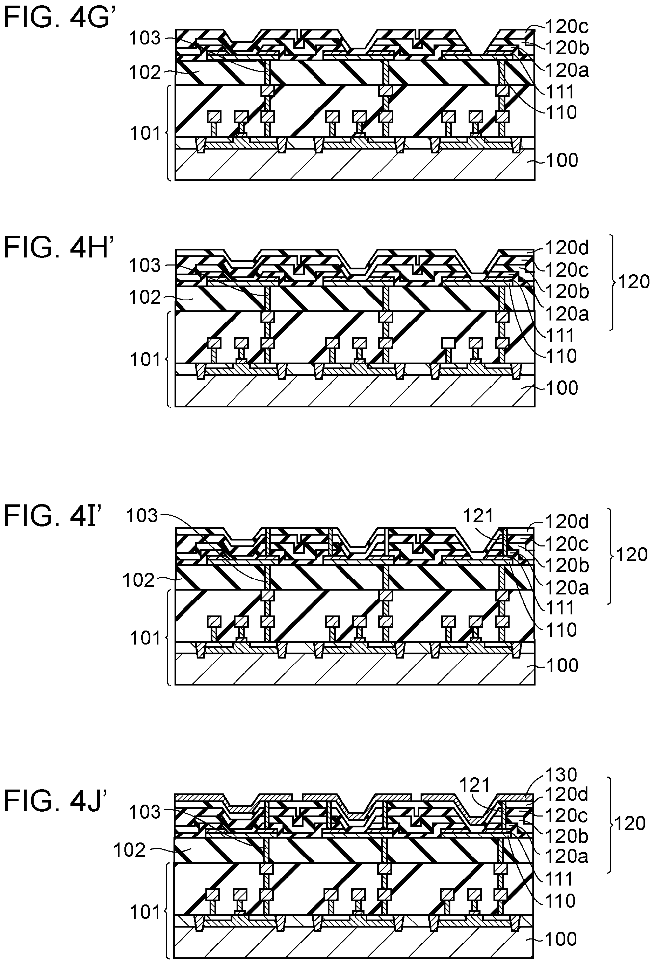

A method for manufacturing the organic device according to the present embodiment will be described with reference to Figs. 4A to 4K. For comparison, Figs. 4C' to 4J' illustrate a manufacturing method according to the related art.

First, as illustrated in Fig. 4A, the drive circuit layer 101 including transistors, capacitors, and a wiring layer is formed on the first principal surface of the substrate 100 by a known complementary metal-oxide-semiconductor (CMOS) process.

Next, an insulating film is deposited to form the interlayer insulating layer 102. The interlayer insulating layer 102 may be formed by plasma chemical vapor deposition (CVD), the high-density plasma method, or a combination of these methods. After the film deposition, the interlayer insulating layer 102 may be subjected to a flattening process by chemical mechanical polishing (CMP). After that, openings are formed in the interlayer insulating layer 102 at predetermined positions. The predetermined positions may be above the wiring layer in the drive circuit layer 101. The openings may be formed by, for example, photolithography or dry etching. The first conductive plugs 103 are formed in the openings. Unnecessary portions may be removed by CMP or etch-back.

Next, as illustrated in Fig. 4B, a multilayer metal film made of titanium (Ti), titanium nitride (TiN), and an aluminum alloy is formed on the interlayer insulating layer 102. The multilayer metal film may include the reflection layer 110 and the antireflection layer 111, and may be formed by sputtering.

After the multilayer metal film is formed, the multilayer metal film is patterned in a predetermined shape by photolithography, dry etching, or wet etching. Thus, the reflection layer 110 and the antireflection layer 111 connected to the first conductive plugs 103 are formed.

Next, as illustrated in Fig. 4C, the openings 141 are formed in the antireflection layer 111 by removing the antireflection layer 111 so that the reflection layer 110 defines the outermost surface of the multilayer metal film. The openings 141 may be formed by photolithography or dry etching. Since the antireflection layer 111 is provided, the accuracy of photolithography is increased, and finer shapes can be formed. The openings 141 may have tapered edges. More specifically, the reflection layer 110 and the antireflection layer 111 may form an acute angle of 30° or more and 50° or less. In this step, the depth of the openings (height h1 in Fig. 3A) may be adjusted to adjust the height h3 of the inclined portion in the fourth region S4 in Fig. 3A. This step is not performed in the manufacturing method according to the related art. Therefore, the shape illustrated in Fig. 4C' is formed.

Next, as illustrated in Fig. 4D, an insulating film is deposited on the reflection layer 110 and the antireflection layer 111 to form a first portion 120a of the first insulating layer 120. The first portion 120a may be formed by plasma CVD. In the manufacturing method according to the related art, the shape illustrated in Fig. 4D' is obtained.

Next, as illustrated in Fig. 4E, an opening is formed at a position in the first pixel 200r. The opening may be formed by photolithography, dry etching, or wet etching. The opening may be formed at least in a pixel in which D1 is largest, and may be formed in each of the RGB pixels simultaneously as long as an optical resonator structure can be formed. The diameter of the opening may be less than the diameter of the openings formed in the reflection layer 110. In the manufacturing method according to the related art, the shape illustrated in Fig. 4E' is obtained.

Next, as illustrated in Figs. 4F to 4H, a second portion 120b, a third portion 120c, and a fourth portion 120d of the first insulating layer 120 and openings therein are successively formed. Thus, optical resonator structures in which film thicknesses D1r, D1g, and D1b in the respective pixels correspond to the colors in the respective pixels can be formed. When the optical resonator structures can be obtained without forming all of the first to fourth portions 120a to 120d of the first insulating layer 120, it is not necessary to form all of the first to fourth portions 120a to 120d of the first insulating layer 120. When the optical resonator structures cannot be obtained after forming all of the first to fourth portions 120a to 120d of the first insulating layer 120, an additional insulating layer may be formed. In the manufacturing method according to the related art, the shapes illustrated in Figs. 4F' to 4H' are obtained.

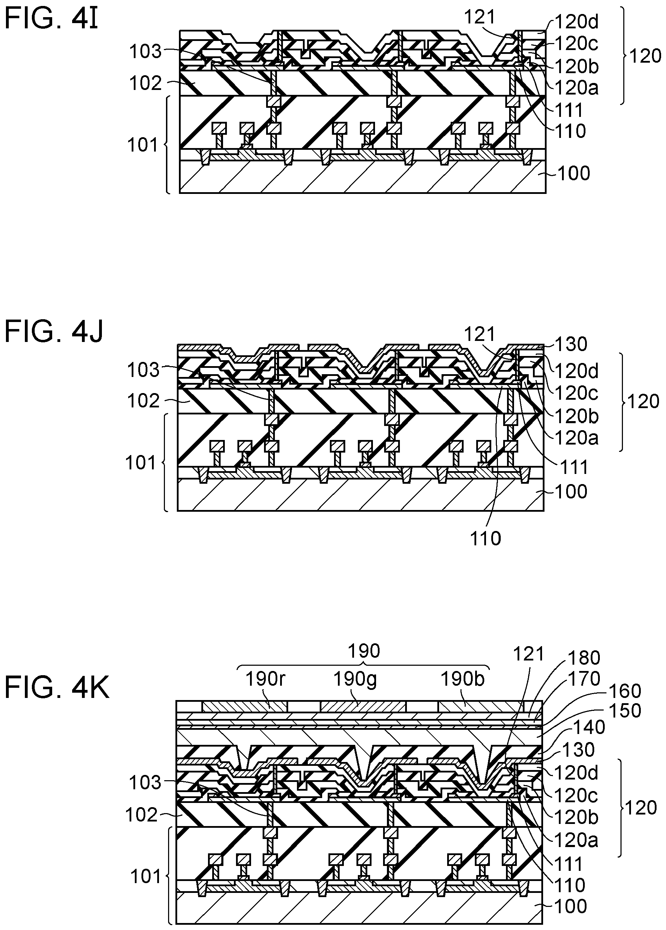

Next, as illustrated in Fig. 4I, openings are formed in the first insulating layer 120 at predetermined positions.

The openings may be formed above the antireflection layer 111. The second conductive plug 121 is formed in each of the openings. Unnecessary portions may be removed by CMP or etch-back.

Next, as illustrated in Fig. 4J, the first electrode 130 is formed, and then patterned by photolithography or dry etching. The formation and patterning of the first electrode 130 may be repeated a plurality of times so that the first electrode 130 has different thicknesses in different pixels. In the manufacturing method according to the related art, the antireflection layer 111 is not etched. Therefore, the first insulating layer 120 and the first electrode 130 formed on the reflection layer 110 and the antireflection layer 111 do not have more than one inclined portions. The height of the inclined portion is affected by the steps formed when the openings are formed in the pixels in the steps illustrated in Figs. 4E' and 4F'. Therefore, according to the manufacturing method of the related art, the increase in resistance and the risk of breakage of the first electrode 130 increase as the thickness of the first electrode 130 decreases.

In contrast, in the organic device according to the present invention, the antireflection layer 111 is etched in the step illustrated in Fig. 4C. Therefore, the first insulating layer 120 and the first electrode 130 formed on the reflection layer 110 and the antireflection layer 111 have more than one inclined portions. Therefore, the height of each inclined portion can be reduced. As a result, according to the organic device of the present invention, the increase in resistance and the risk of breakage of the first electrode 130 can be reduced.

In addition, according to the organic device of the present invention, the increase in resistance and the risk of breakage of the first electrode 130 can be reduced when the thickness of the first electrode 130 is reduced.

Lastly, as illustrated in Fig. 4K, the components from the openings 141 to the color filters 190 are formed by known methods. Thus, the organic device 1 is formed.

### Second Embodiment

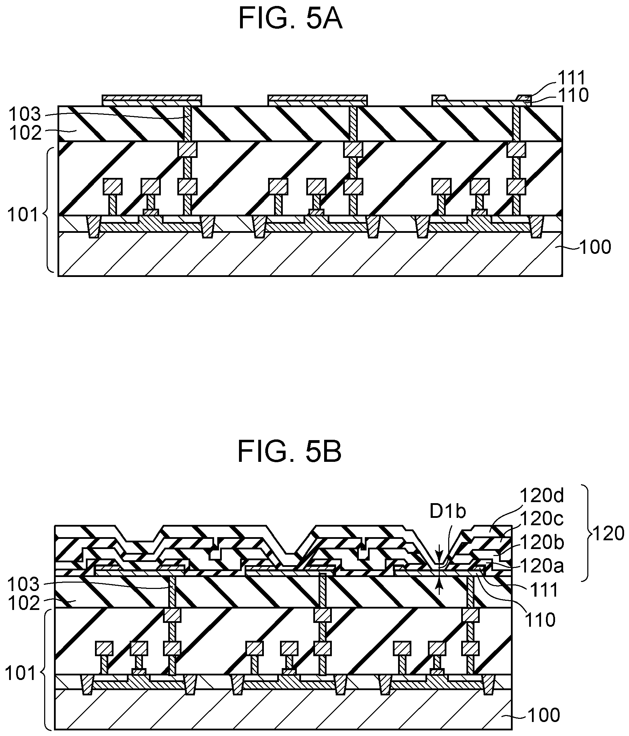

An organic device 1 according to a second embodiment will be described with reference to Figs. 5A and 5B. Figs. 5A and 5B illustrate a method for manufacturing the organic device 1 according to the second embodiment.

In the second embodiment, only one or more of the plurality of pixels 200 included in the organic device 1 have a plurality of inclined portions. More specifically, the organic device 1 includes a plurality of pixels including a first pixel and a second pixel. The first electrode included in the first pixel includes the first region S1, the second region S2, the third region S3, and the fourth region S4. The first electrode included in the second pixel includes the first region S1, the sixth region S6, and the seventh region S7.

In the present embodiment, the pixel including the plurality of inclined portions may be any pixel, and may be a pixel having a small optical adjustment film thickness D1 and the largest height h1. This is because the pixels having a larger height h1 has a greater risk of breakage of the first electrode 130. The antireflection layer 111 may be patterned for pixels other than a pixel having a largest optical adjustment film thickness D1 and a smallest height h1.

In the organic device 1 according to the second embodiment, as illustrated in Fig. 5A, the antireflection layer 111 is patterned only in the pixel in which a plurality of inclined portions are to be formed.

Then, similarly to the above-described steps illustrated in Figs. 4D to 4I, formation of the first insulating layer 120 and formation of an opening are repeated to form the shape having a plurality of inclined portions only in the predetermined pixel, as illustrated in Fig. 5B.

In the organic device 1 according to the second embodiment, only the pixel with a risk of breakage of the first electrode 130 due to reduction in the thickness of the first electrode 130 has the structure of the present invention. Thus, the opening ratio of the pixels can be increased.

### Third Embodiment

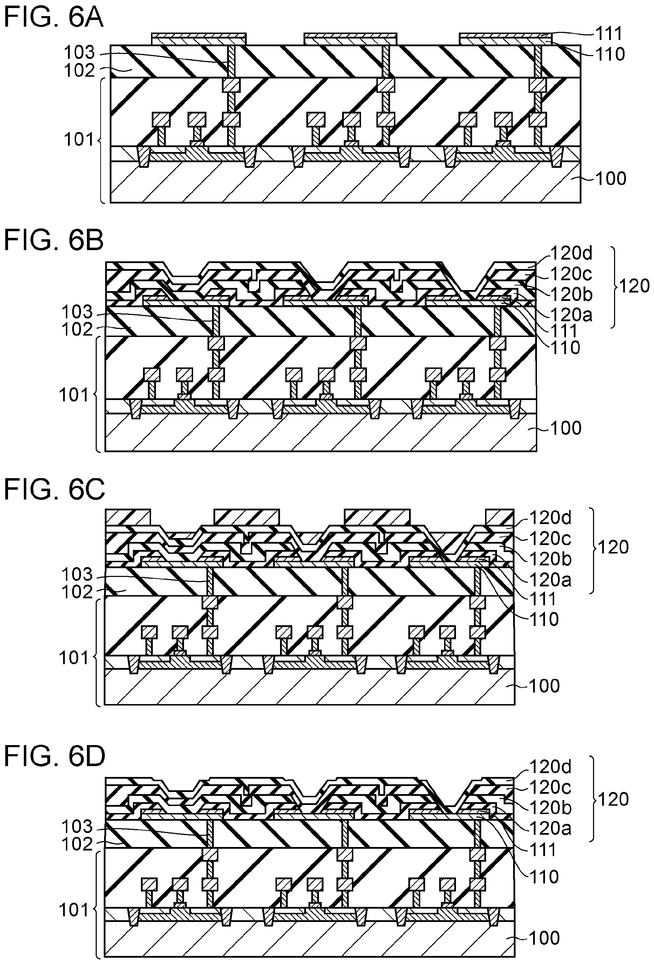

An organic device 1 according to a third embodiment will be described with reference to Figs. 6A to 6D. Figs. 6A to 6D illustrate a method for manufacturing the organic device 1 according to the third embodiment.

According to the third embodiment, the plurality of inclined portions can be formed without patterning the antireflection layer 111.

First, as illustrated in Fig. 6A, the reflection layer 110 and the antireflection layer 111 are formed by the same processes as those in Figs. 4A and 4B.

Next, as illustrated in Fig. 6B, formation of the first insulating layer 120 and formation of openings are repeated by the same processes as those in Figs. 4D to 4H without patterning the antireflection layer 111. As a result, the shape illustrated in Fig. 6B is obtained.

Next, as illustrated in Fig. 6C, resist is formed in the openings 141 and on the fourth portion 120d of the first insulating layer 120 at the highest position by photolithography.

It is not necessary to fill the openings 141 with the resist. As illustrated in Fig. 6C, the resist may be formed such that corners of the inclined portions are exposed. In addition, it is not necessary that the resist entirely cover the fourth portion 120d of the first insulating layer 120 at the highest position. The resist may partially cover the fourth portion 120d.

Lastly, dry etching is performed so that the shape illustrated in Fig. 6D, in which each pixel has a plurality of inclined portions, is obtained.

According to the organic device of the present embodiment, h3 can be adjusted by adjusting the shape of the resist and etching conditions. Therefore, h3 can be adjusted more easily than in the organic devices according to the first and second embodiments.

### Applications

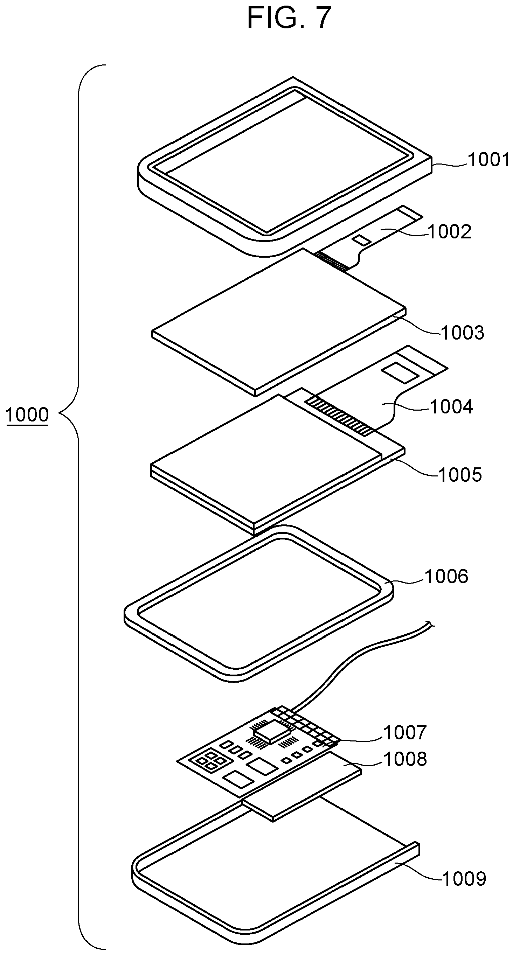

Fig. 7 is a schematic diagram illustrating an example of a display apparatus according to an embodiment. A display apparatus 1000 may include, between an upper cover 1001 and a lower cover 1009, a touch panel 1003, a display panel 1005, a frame 1006, a circuit board 1007, and a battery 1008. Flexible printed circuits (FPC) 1002 and 1004 are connected to the touch panel 1003 and the display panel 1005, respectively. The display panel 1005 may include the organic device according to the present invention. Transistors are printed on the circuit board 1007. When the display apparatus is not portable, the battery 1008 may be omitted. When the display apparatus is portable, the battery 1008 may be placed at a separate location.

The display apparatus according to the embodiment may include red, green, and blue color filters. The red, green, and blue color filters may be arranged in a delta pattern.

The display apparatus according to the embodiment may be used in a display unit of an imaging device including an imaging element that receives light. The imaging device may include the display unit that displays information obtained by the imaging element. The display unit may be either a display unit exposed to the outside of the imaging device or a display unit disposed in a finder. The imaging device may be a digital camera or a digital video camera.

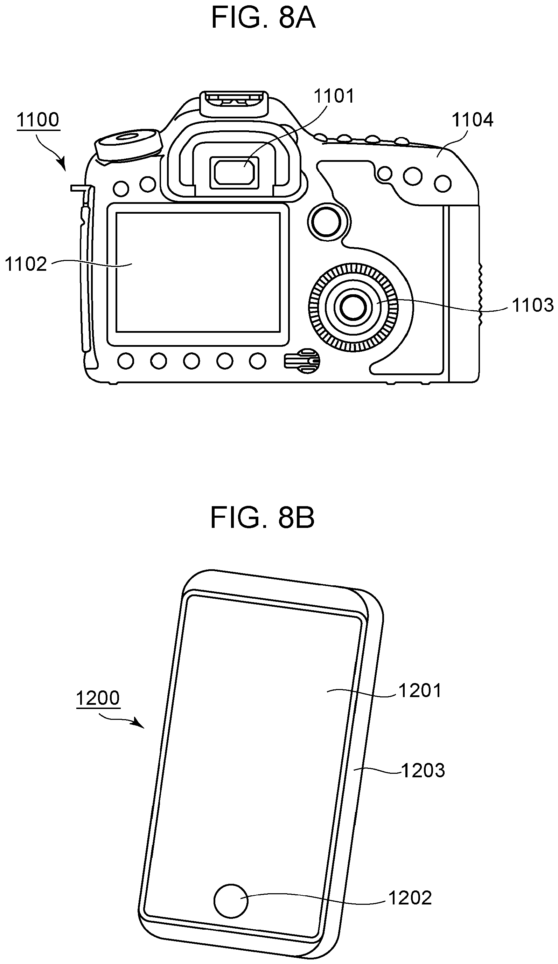

Fig. 8A is a schematic diagram illustrating an example of an imaging device according to an embodiment. An imaging device 1100 may include a viewfinder 1101, a back display 1102, an operation unit 1103, and a housing 1104. The viewfinder 1101 and the back display 1102 may each include the organic device according to the present invention. In such a case, each display apparatus may display not only an image to be captured but also environmental information and imaging instructions. The environmental information may include the intensity and direction of external light, the moving speed of a subject, and the possibility of the subject being blocked by an object.

The imaging device 1100 may additionally include an optical unit (not illustrated). The optical unit may include one lens or a plurality of lenses, and focuses light on an imaging element disposed in the housing 1104. The relative positions of the lenses can be adjusted to adjust the focal point. This operation can be performed automatically. The imaging device may also be referred to as a photoelectric conversion apparatus. Instead of capturing images one by one, the photoelectric conversion apparatus may employ a method of capturing an image by detecting a difference from the previous image or by extracting an image from continuously recorded images.

Fig. 8B is a schematic diagram illustrating an example of an electronic apparatus according to an embodiment. An electronic apparatus 1200 includes a display unit 1201, an operation unit 1202, and a housing 1203. The housing 1203 may contain a circuit, a printed board having the circuit, a battery, and a communication unit. The operation unit 1202 may be a button or a touch-panel reaction unit. The operation unit 1202 may be a biometric identification unit that recognizes fingerprints and unlocks the device, for example. The electronic apparatus including the communication unit may also be regarded as a communication apparatus. The electronic apparatus may also include a lens and an imaging element and have a camera function. The display unit 1201 displays an image captured by using the camera function. The electronic apparatus may be, for example, a smartphone or a notebook personal computer.

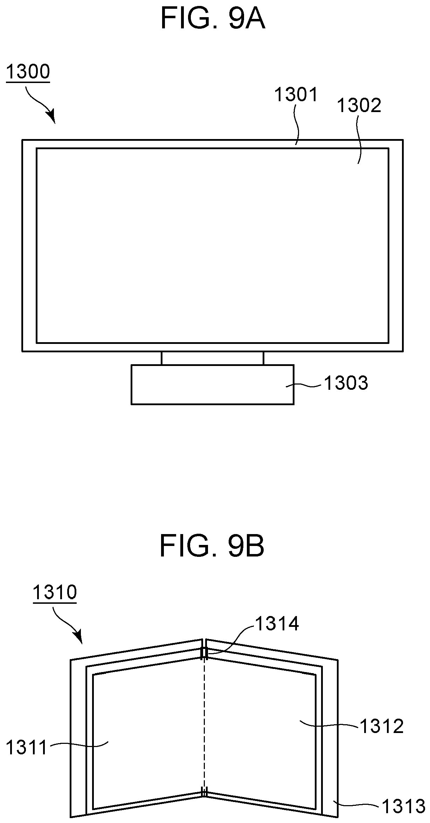

Figs. 9A and 9B are schematic diagrams of examples of display apparatuses according to embodiments. Fig. 9A illustrates a display apparatus such as a television monitor or a personal computer (PC) monitor. The display apparatus 1300 includes a housing 1301 and a display unit 1302. The display unit 1302 may include the organic device according to the present invention.

The display apparatus 1300 may also include a base 1303 that supports the housing 1301 and the display unit 1302. The form of the base 1303 is not limited to that illustrated in Fig. 9A. The bottom side of the housing 1301 may serve as the base.

The housing 1301 and the display unit 1302 may be curved. The radius of curvature may be 5000 mm or more and 6000 mm or less.

Fig. 9B is a schematic diagram illustrating another example of a display apparatus according to an embodiment. A display apparatus 1310 illustrated in Fig. 9B is a foldable display apparatus that is capable of being folded. The display apparatus 1310 includes a first display unit 1311, a second display unit 1312, a housing 1313, and a folding point 1314. The first display unit 1311 and the second display unit 1312 may each include the organic device according to the present invention. The first display unit 1311 and the second display unit 1312 may constitute a single seamless display apparatus. The first display unit 1311 and the second display unit 1312 may be sectioned from each other at the folding point. The first display unit 1311 and the second display unit 1312 may display different images. Alternatively, the first display unit 1311 and the second display unit 1312 may display a single image together.

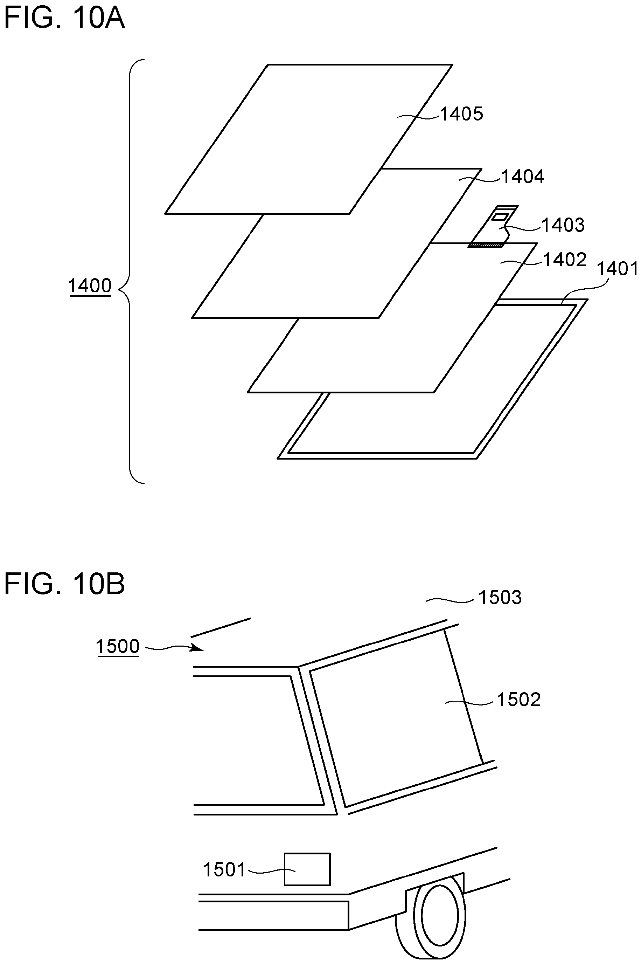

Fig. 10A is a schematic diagram illustrating an example of an illumination apparatus according to an embodiment. An illumination apparatus 1400 may include a housing 1401, a light source 1402, and a circuit board 1403. The light source 1402 may include the organic device according to the present invention. The illumination apparatus 1400 may include an optical film 1404 for improving the color rendering properties of the light source 1402. The illumination apparatus 1400 may include a light diffuser 1405 to effectively diffuse light from the light source 1402. The illumination apparatus 1400 can deliver light to a larger area when the light diffuser 1405 is included therein. The optical film 1404 and the light diffuser 1405 may be disposed on a light emission side of the illumination apparatus. A cover may be provided on an outermost portion as necessary.

The illumination apparatus is, for example, an indoor illumination apparatus. The color of light emitted from the illumination apparatus may be white, daylight white, or any color in the range from blue to red. The illumination apparatus may include a light control circuit that controls the light to be emitted. The illumination apparatus may include a power supply circuit. The power supply circuit may be a circuit that converts an alternating current voltage into a direct current voltage. Here, "white" is a color with a color temperature of 4200K, and "daylight white" is a color with a color temperature of 5000K. The illumination apparatus may include a color filter.

The illumination apparatus according to the embodiment may include a heat dissipation unit. The heat dissipation unit dissipates heat in the apparatus to the outside of the apparatus, and is made of, for example, a metal or ceramic having a high thermal conductivity.

Fig. 10B is a schematic diagram illustrating an automobile as an example of a moving object according to an embodiment. The automobile includes a taillight as an example of a lighting tool. The automobile 1500 includes a taillight 1501. The taillight 1501 may be configured to turn on when a brake is applied. The automobile 1500 may include a vehicle body 1503 and a window 1502 attached to the vehicle body 1503.

The taillight 1501 may include the organic device according to the present invention. The taillight may include a protective member that protects a light source. The protective member may be made of any material that has a relatively high strength and that is transparent, and may be made of, for example, polycarbonate. The polycarbonate may be mixed with, for example, a furandicarboxylic acid derivative or an acrylonitrile derivative.

The moving object according to the embodiment may be, for example, an automobile, a ship, an aircraft, or a drone. The moving object may include a body and a lighting tool provided on the body. The lighting tool may emit light to show the position of the body.

The electronic apparatus or the display apparatus may be applied to a system attachable to a user as a wearable device, such as smart glasses, a head mount display, or smart contact lenses. The electronic apparatus may include an imaging device capable of performing photoelectric conversion on visible light and a display apparatus capable of emitting visible light.

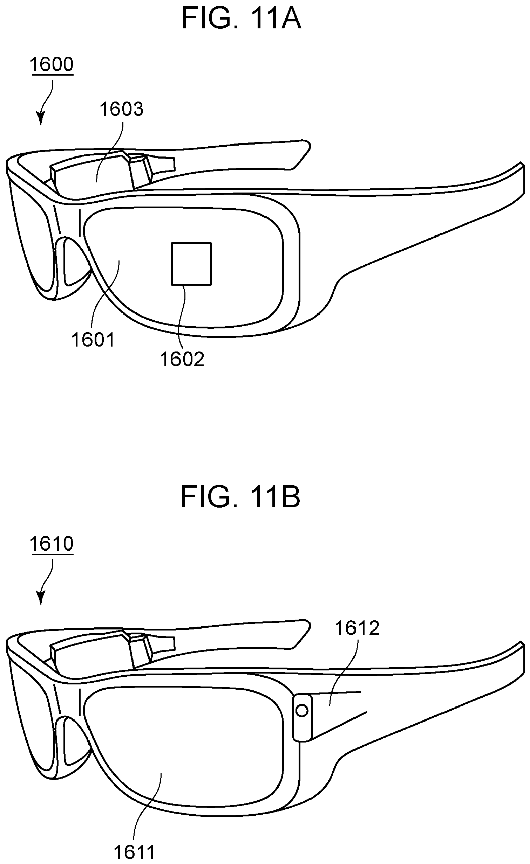

Figs. 11A and 11B are schematic diagrams illustrating examples of eyeglasses (smart glasses) according to embodiments. Eyeglasses 1600 (smart glasses) will be described with reference to Fig. 11A. The eyeglasses 1600 include a display unit on a back surface of a lens 1601. The display unit may include the organic device according to the present invention. An imaging device 1602, such as a CMOS sensor or a single photon avalanche diode (SPAD) sensor, may be provided on a front surface of the lens 1601.

The eyeglasses 1600 further include a control device 1603. The control device 1603 serves as a power supply that supplies electric power to the imaging device 1602 and the display unit. The control device 1603 controls the operations of the imaging device 1602 and the display unit. The lens 1601 includes an optical system for collecting light of the imaging device 1602 and the display unit.

Eyeglasses 1610 (smart glasses) will be described with reference to Fig. 11B. The eyeglasses 1610 include a control device 1612, and the control device 1612 includes a display apparatus including the organic device according to the present invention. The control device 1612 may further include an imaging device corresponding to the imaging device 1602. A lens 1611 includes an optical system for projecting light emitted from the control device 1612, and an image is projected onto the lens 1611. The control device 1612 serves as a power supply that supplies electric power to the imaging device and the display apparatus, and also controls the operations of the imaging device and the display apparatus. The control device may also include a line-of-sight detector that detects the line of site of a wearer. Infrared light may be used to detect the light of sight. An infrared-light-emitting unit emits infrared light toward an eyeball of a user looking at a displayed image. A portion of the emitted infrared light that is reflected by the eyeball is detected by an imaging unit including a light receiving element. Thus, an image of the eyeball can be obtained. When a light reducing unit is provided to reduce light traveling from the infrared-light-emitting unit to the display unit in plan view, degradation of the image quality can be reduced.

The control device 1612 detects the line of site of the user viewing the display image based on the eyeball image captured by receiving the infrared light. Any known method may be used to detect the line of sight based on the captured eyeball image. For example, the line of sight can be detected based on a Purkinje image obtained by reflection of irradiation light by the cornea.

More specifically, a line-of-sight detection process is performed in accordance with the pupil-cornea reflection method. The pupil-cornea reflection method is used to create a line-of-sight vector showing the orientation (rotation angle) of the eyeball based on an image of the pupil and a Purkinje image included in the captured eyeball image. Thus, the line of sight of the user can be detected.

The display apparatus according to the embodiment of the present invention may include the imaging device including the light receiving element, and may control an image displayed by the display apparatus based on information regarding the line of sight of the user obtained by the imaging device.

More specifically, the display apparatus may determine a first viewing region and a second viewing region based on the information regarding the line of sight. The first viewing region is a region the user is looking at, and the second viewing region is a region other than the first viewing region. The first viewing region and the second viewing region may be determined by the control device included in the display apparatus, or be determined by an external control device and transmitted to the display apparatus. The display resolution in a display region of the display apparatus may be controlled such that the display resolution is higher in the first viewing region than in the second viewing region. In other words, the resolution may be lower in the second viewing region than in the first viewing region.

Artificial intelligence (AI) may be used to determine the first display region or a display region with high priority. The AI may be a model configured to estimate the angle of the line of sight and the distance to an object on the line of sight based on the eyeball image by using teacher data including eyeball images and the actual directions of sight of the eyeballs in the images. The AI may be included in the display apparatus, the imaging device, or an external device. The AI included in the external device is suitable for application to smart glasses further including an imaging device that captures an image of the outside. The smart glasses are capable of displaying information of the outside in the captured image in real time.

As described above, according to the organic device of the present invention, the electrode does not easily break. In addition, the increase in the resistance of the electrode can be reduced. It is needless to say that the present invention is not limited to the above-described embodiments, and modifications and combinations of the above-described embodiments are possible without departing from the gist of the present invention.

The present invention includes the following configurations.

(Configuration 1) An organic device including a reflection layer, a first electrode, an organic layer, and a second electrode arranged in that order above a first principal surface of a substrate, wherein the first electrode includes a first region, a second region, a third region, and a fourth region, the first region being in contact with the organic layer, the second region being inclined in a direction away from the substrate, the third region having an inclination less than an inclination of the second region with respect to the substrate, and the fourth region being inclined in the direction away from the substrate and having an inclination greater than the inclination of the third region with respect to the substrate, and wherein the first region and the second region are in contact with each other, the second region and the third region are in contact with each other, and the third region and the fourth region are in contact with each other.

(Configuration 2) The organic device according to Configuration 1, wherein a distance between the third region and the first principal surface in a direction perpendicular to the first principal surface is greater than a distance between the first region and the first principal surface in the direction perpendicular to the first principal surface.

(Configuration 3) The organic device according to Configuration 1 or 2, wherein the first electrode is parallel to the substrate in the third region.

(Configuration 4) The organic device according to Configuration 1 or 2, wherein the first electrode is inclined in the direction away from the substrate in the third region.

(Configuration 5) The organic device according to any one of Configurations 1 to 4, wherein the first electrode further includes a fifth region in contact with the fourth region, and wherein the fifth region is electrically connected to the reflection layer.

(Configuration 6) The organic device according to any one of Configurations 1 to 5, wherein the organic device includes a plurality of pixels including a first pixel and a second pixel and an insulating layer disposed between the reflection layer and the first electrode, and wherein a thickness of the insulating layer in the direction perpendicular to the first principal surface in the first region of the first electrode included in the first pixel differs from a thickness of the insulating layer in the direction perpendicular to the first principal surface in the first region of the first electrode included in the second pixel.

(Configuration 7) The organic device according to Configuration 6, wherein a height of the second region is a distance from a lower surface of the first electrode in the first region to a lower surface of the first electrode at a highest position in the second region in the direction perpendicular to the first principal surface, and wherein the height of the second region in the first pixel differs from the height of the second region in the second pixel.

(Configuration 8) The organic device according to any one of Configurations 1 to 7, wherein the first electrode is a transparent electrode.

(Configuration 9) The organic device according to any one of Configurations 1 to 8, wherein the organic device includes a plurality of pixels including a first pixel and a second pixel, wherein the first electrode included in the first pixel includes the first region, the second region, the third region, and the fourth region, wherein the first electrode included in the second pixel includes the first region, a sixth region, and a seventh region, the sixth region being inclined in the direction away from the substrate, the seventh region having an inclination less than an inclination of the sixth region with respect to the substrate, and wherein the sixth region and the seventh region are in contact with each other.

(Configuration 10) A photoelectric conversion apparatus including an imaging element that receives light and a display unit that displays an image captured by the imaging element, wherein the display unit is the organic device according to any one of Configurations 1 to 9.

(Configuration 11) A display apparatus including a display unit including the organic device according to any one of Configurations 1 to 9, and a housing on which the display unit is provided.

(Configuration 12) An electronic apparatus including a display unit including the organic device according to any one of Configurations 1 to 9, a housing on which the display unit is provided, and a communication unit that is provided in the housing and that communicates with an outside of the electronic apparatus.

(Configuration 13) An illumination apparatus including a light source including the organic device according to any one of Configurations 1 to 9, and a housing in which the light source is provided.

(Configuration 14) A moving object including a lighting tool including the organic device according to any one of Configurations 1 to 9, and a body on which the lighting tool is provided.

(Configuration 15) A wearable device including a display unit including the organic device according to any one of Configurations 1 to 9, an optical system that collects light of the display unit, and a control device that controls an operation of the display unit.

According to the present invention, an organic device in which breakage of an electrode does not easily occur can be provided.

While the present invention has been described with reference to embodiments, it is to be understood that the invention is not limited to the disclosed embodiments. The scope of the following claims is to be accorded the broadest interpretation so as to encompass all such modifications and equivalent structures and functions.

## Claims

1. An organic device (1) comprising:
a reflection layer (110), a first electrode (130), an organic layer (150), and a second electrode (160) arranged in that order above a first principal surface of a substrate (100),
wherein the first electrode (130) includes a first region (S1), a second region (S2), a third region (S3), and a fourth region (S4), the first region (S1) being in contact with the organic layer (150), the second region (S2) being inclined in a direction away from the substrate (100), the third region (S3) having an inclination less than an inclination of the second region (S2) with respect to the substrate (100), and the fourth region (S4) being inclined in the direction away from the substrate (100) and having an inclination greater than the inclination of the third region (S3) with respect to the substrate (100), and
wherein the first region (S1) and the second region (S2) are in contact with each other, the second region (S2) and the third region (S3) are in contact with each other, and the third region (S3) and the fourth region (S4) are in contact with each other.

2. The organic device (1) according to Claim 1, wherein a distance between the third region (S3) and the first principal surface in a direction perpendicular to the first principal surface is greater than a distance between the first region (S1) and the first principal surface in the direction perpendicular to the first principal surface.

3. The organic device (1) according to Claim 1 or 2, wherein the first electrode (130) is parallel to the substrate (100) in the third region (S3).

4. The organic device (1) according to Claim 1 or 2, wherein the first electrode (130) is inclined in the direction away from the substrate (100) in the third region (S3).

5. The organic device (1) according to any one of Claims 1 to 4, wherein the first electrode (130) further includes a fifth region (S5) in contact with the fourth region (S4), and
wherein the fifth region (S5) is electrically connected to the reflection layer (110).

6. The organic device (1) according to any one of Claims 1 to 5, wherein the organic device (1) includes a plurality of pixels (200) including a first pixel (200r) and a second pixel (200g) and an insulating layer (120) disposed between the reflection layer (110) and the first electrode (130), and
wherein a thickness of the insulating layer (120) in the direction perpendicular to the first principal surface in the first region (S1) of the first electrode (130) included in the first pixel (200r) differs from a thickness of the insulating layer (120) in the direction perpendicular to the first principal surface in the first region (S1) of the first electrode (130) included in the second pixel (200g).

7. The organic device (1) according to Claim 6, wherein a height (h2) of the second region (S2) is a distance from a lower surface of the first electrode (130) in the first region (S1) to a lower surface of the first electrode (130) at a highest position in the second region (S2) in the direction perpendicular to the first principal surface, and
wherein the height (h2) of the second region (S2) in the first pixel (200r) differs from the height (h2) of the second region (S2) in the second pixel (200g).

8. The organic device (1) according to any one of Claims 1 to 7, wherein the first electrode (130) is a transparent electrode.

9. The organic device (1) according to any one of Claims 1 to 8, wherein the organic device (1) includes a plurality of pixels (200) including a first pixel (200r) and a second pixel (200g),
wherein the first electrode (130) included in the first pixel (200r) includes the first region (S1), the second region (S2), the third region (S3), and the fourth region (S4),
wherein the first electrode (130) included in the second pixel (200g) includes the first region (S 1), a sixth region (S6), and a seventh region (S7), the sixth region (S6) being inclined in the direction away from the substrate (100), the seventh region (S7) having an inclination less than an inclination of the sixth region (S6) with respect to the substrate (100), and
wherein the sixth region (S6) and the seventh region (S7) are in contact with each other.

10. A photoelectric conversion apparatus (1100) comprising:
an imaging element that receives light; and
a display unit that displays an image captured by the imaging element,
wherein the display unit is the organic device (1) according to any one of Claims 1 to 9.

11. A display apparatus (1000, 1300, 1310) comprising:
a display unit including the organic device (1) according to any one of Claims 1 to 9; and
a housing on which the display unit is provided.

12. An electronic apparatus (1200) comprising:
a display unit (1201) including the organic device (1) according to any one of Claims 1 to 9;
a housing (1203) on which the display unit (1201) is provided; and
a communication unit that is provided in the housing (1203) and that communicates with an outside of the electronic apparatus (1200).

13. An illumination apparatus (1400) comprising:
a light source (1402) including the organic device (1) according to any one of Claims 1 to 9; and
a housing in which the light source (1402) is provided.

14. A moving object (1500) comprising:
a lighting tool (1501) including the organic device (1) according to any one of Claims 1 to 9; and
a body (1503) on which the lighting tool (1501) is provided.

15. A wearable device (1600, 1610) comprising:
a display unit including the organic device (1) according to any one of Claims 1 to 9;
an optical system that collects light of the display unit; and
a control device (1603, 1612) that controls an operation of the display unit.
